# EUROPEAN PATENT APPLICATION

(11) **EP 4 593 066 A1**
(43) Date of publication of application: **30.07.2025**
(21) Application number: 24305139.8
(22) Date of filing: 25.01.2024
(51) Int. Cl.: H01L 21/48, H01L 23/473

(54) **COOLING BLOCK FOR COOLING A HEAT-GENERATING ELECTRONIC COMPONENT**

(71) Applicant: OVH, 59100 Roubaix (FR)
(72) Inventor: BAUDUIN, Hadrien, 59650 Villeneuve d'Ascq (FR); BAUCHART, Grégory Francis Louis, 59150 Wattrelos (FR); VAHIDI FERDOUSI, Mahdi, 59800 Lille (FR); CHEHADE, Ali, 59283 Moncheaux (FR)
(74) Representative: BCF Global

(57) **Abstract**

A method for making a cooling block for cooling a heat-generating electronic component. The method includes providing a base defining an open passage and a protrusion and providing a cover positionable on the base to close the open passage forming a fluid conduit. The cover has an underside defining a recess which receives at least a free end of the protrusion. The method includes positioning the cover on the base such that at least the free end of the protrusion is received in the recess and the open passage is closed to form the fluid conduit and welding an outer side of the cover, along a weld path which includes at least a portion on the cover above the recess. A cooling block made by the method.

## Description

### FIELD OF TECHNOLOGY

The present technology relates to cooling blocks for cooling heat-generating electronic components.

### BACKGROUND

Heat dissipation is an important consideration for computer systems. Notably, many components of a computer system, such as a processor (also referred to as central processing unit (CPU)), generate heat and require cooling to avoid performance degradation and, in some cases, failure. Similar considerations arise for systems other than computer systems (e.g., power management systems). Thus, in many cases, different types of cooling solutions are implemented to promote heat dissipation from heat-generating electronic components, with the objective being to collect and conduct thermal energy away from these heat-generating electronic components. For instance, in a data center, in which multiple electronic systems (e.g., servers, networking equipment, power equipment) are continuously operating and generating heat, such cooling solutions may be particularly important.

One example of a cooling solution is a heat sink which relies on a heat transfer medium (e.g., a gas or liquid) to carry away the heat generated by a heat-generating electronic component. For instance, a cooling block (sometimes referred to as a "water block" or "cold plate") can be thermally coupled to a heat-generating electronic component, and water (or other fluid) is made to flow through a conduit in the cooling block to absorb heat from the heat-generating electronic component. As water flows out of the cooling block, so does the thermal energy.

Cooling blocks include a base and a cover which, together, define a fluid conduit that the cooling fluid flows through. The cover is positioned overtop of the base and the cover and the base are sealed together using a laser welding process. During the laser welding process, a large amount of heat is generated which often leads to deformation of the geometry of the base and/or the cover of the cooling block. In some instances, the deformation results in the fluid pathway being "short circuited", by-passing the expected fluid pathway through gaps between the base and the cover, ultimately, leading to a degradation of performance of the cooling block.

There is therefore a desire for a cooling block which can alleviate at least some of these drawbacks.

### SUMMARY

It is an object of the present technology to ameliorate at least some of the inconveniences present in the prior art.

The developers have identified some inefficiencies associated with manufacturing cooling blocks. During manufacturing, the methods comprise laser welding of base and cover components to form a single body with a fluid pathway defined therein. Such laser welding methods generate significant heat that can deform the geometry of the cover and/or the base. Deformation can result in one or more short circuits occurring in the fluid pathway, resulting in an incomplete fluid pathway and hence a degradation of a performance of the cooling block.

Broadly, there is provided a cooling block in which there is provided a structural or mechanical connection between inter-engaging components of the base and the cover during manufacturing of the cooling block. Developers have discovered that welding the cover and the base after engagement of the inter-engaging components, reduces the likelihood of warping that results in short-circuiting of the fluid pathway. The inter-engaging components of the base and the cover may comprise at least one protrusion associated with the base and at least one recess, configured to house at least a free end portion of the at least one protrusion, associated with the cover.

According to one aspect of the present technology, there is provided a method for making a cooling block for cooling a heat-generating electronic component. The method includes providing a base having defined therein at least one open passage and at least one protrusion extending upwardly relative to a bottom of the at least one open passage; providing a cover which is configured to be positionable on the base such that it closes the at least one open passage to form at least one fluid conduit, the cover having an outer side, and an underside defining at least one recess which is configured to receive at least a free end of the at least one protrusion; positioning the cover on the base such that at least the free end of the at least one protrusion is received in the at least one recess and the at least one open passage is closed to form the at least one fluid conduit; and welding together the cover and the base, from the outer side of the cover, along a weld path which includes at least a portion on the cover above the at least one recess.

In some implementations, the base has side walls defining a pocket, the at least one open passage being defined in the pocket, the side walls of the base having a shelf on which the cover can sit, wherein a height of the at least one protrusion from the bottom of the at least one open passage is higher than a height of the shelf from the bottom of the at least one open passage.

In some implementations, the base has side walls defining a pocket, the at least one open passage being defined in the pocket, the side walls of the base having a shelf on which the cover can sit, further comprising inter-connectable members associated with the shelf and the cover.

In some implementations, the cover has a cover body, a thickness of the cover body at a portion of the cover including the at least one recess is less than a thickness of the cover body at a portion not including the at least one recess.

In some implementations, the at least one protrusion includes at least one passage wall of the at least one open passage, wherein at least a free end of the passage wall is received in the recess of the cover.

In some implementations, the at least one open passage includes two passages and the at least one open passage wall separates the two passages.

In some implementations, the at least one open passage includes at least one passage wall having a passage wall free end, and the at least one protrusion includes at least one elongate member disposed on, and extending at least partially along, the passage wall free end.

In some implementations, the at least one open passage extends transversely to a side wall of the base, at a point of connection to the side wall, and wherein the at least one elongate member is contingent with the side wall of the base.

In some implementations, the at least one recess corresponding to the at least one elongate member is open to a side wall of the cover.

In some implementations, the at least one open passage extends transversely from a side wall of the base, at a point of connection to the side wall, and wherein the at least one elongate member is spaced from the side wall of the base.

In some implementations, the at least one recess corresponding to the at least one protrusion is closed to a side wall of the cover.

In some implementations, the at least one elongate member includes two elongate members which are disposed parallel to one another along the passage wall free end.

In some implementations, the at least one elongate member has a U-shaped, an L shaped or a hollow configuration.

In some implementations, the at least one protrusion includes a plurality of pins spaced from one another along the passage wall free end, and the at least one recess includes a plurality of recesses, each recess being sized and shaped to receive a respective one of the plurality of pins.

In some implementations, each pin has a circular cross-section along a plane which is parallel to the bottom of the at least one open passage.

In some implementations, each pin has a U-shaped, L-shaped or donut cross-section along a plane which is parallel to the bottom of the at least one open passage.

In some implementations, the method further includes forming the at least one recess by milling.

In some implementations, the method further includes forming at least a portion of the at least one protrusion by milling.

In some implementations, the welding is performed using one or more of laser, plasma, friction or ultrasound welding.

In some implementations, the welding includes at least one of: welding corners of the cover to the base, welding edge midpoints of the cover to the base, welding the at least one protrusion within the at least one recess, and welding along a perimeter of the cover. In some embodiments, the welding edge midpoints of the cover to the base and/or welding corners of the cover to the base comprises spot welding.

In another aspect of the present technology, a cooling block including a body having defined therein at least one fluid conduit, the cooling block made according to the method previously described.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

It is to be understood that terms relating to the position and/or orientation of components such as "upper", "lower", "top", "bottom", "front", "rear", "left", "right", "longitudinal", "lateral", "vertical", etc. are used herein to simplify the description and are not intended to be limitative of the particular position/orientation of the components in use.

It must be noted that, as used in this specification and the appended claims, the singular form "a", "an" and "the" include plural referents unless the context clearly dictates otherwise.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a perspective view, taken from a top, front, left side of a cooling blocking having a base and a cover and inter-engagement between the base and the cover, as well as a heat generating electronic component cooled thereby, according to implementations of the present technology;
Figure 2 is a top plan view of the base of the cooling block of Figure 1, according to an implementation of the present technology;
Figure 3 is a cross-sectional view of the cooling block of Figure 1 taken along line A-A in Figure 1, and showing inter-engagement between the base and the cover in which the inter-engagement comprises passage walls associated with the base receivable in recesses associated with the cover, according to implementations of the present technology;
Figure 4 is a perspective view, taken from a top, front, right side, of a base of the cooling block of Figure 2 a in which the inter-engagement between the base and the cover comprises elongate protrusions associated with the base and recesses associated with the cover, according to implementations of the present technology.
Figure 5 is a perspective view, taken from a bottom, rear, right side of a lower side of a cover associated with the base of Figure 4 and the cooling block of Figure 1, according to an implementation of the present technology;
Figure 6 is a cross-sectional view of the cooling block of Figure 4 taken along line A-A in Figure 1;
Figure 7 is a perspective view, taken from a top, front, right side, of a base and a cover, shown transparently, of the cooling block of Figure 1, in which the inter-engagement between the base and cover comprises pins associated with the base, according to other implementations of the present technology;
Figure 8 is a cross-sectional view of the cooling block of Figure 7 taken along line A-A in Figure 1;
Figure 9 is a bottom plan view of a cover associated with the base of Figure 7 and the cooling block of Figure 1; and
Figure 10 is a flow chart of a method of manufacturing the cooling block of Figure 1, according to an implementation of the present technology.

It should be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding and, again, not to define the scope or set forth the bounds of the present technology. These modifications are not an exhaustive list, and a person skilled in the art may make other modifications while nonetheless remain within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

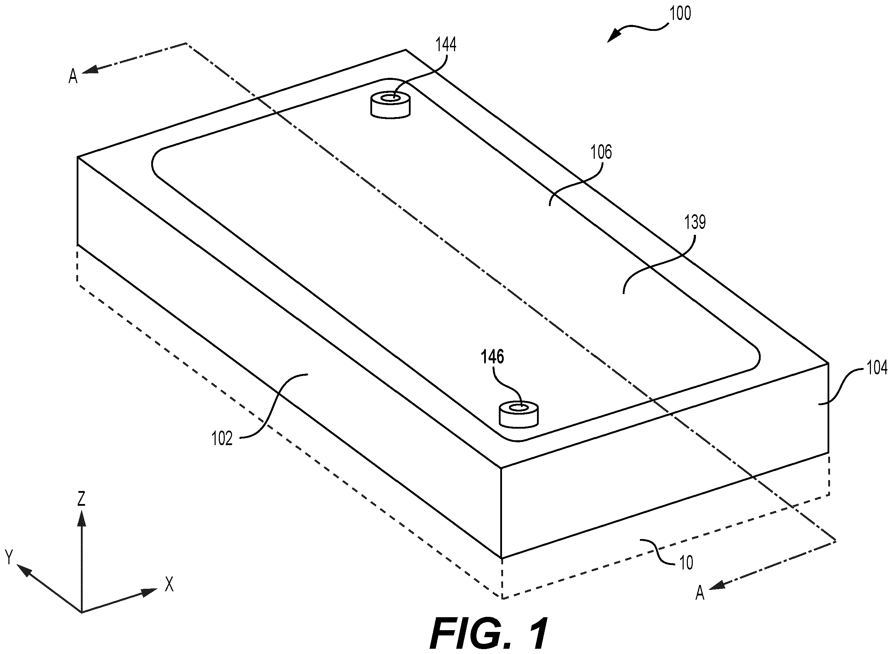

With reference to Figures 1, 3, 6, and 8, a cooling block 100 of the present technology is depicted. The cooling block 100 has a body 102 including a base 104 and a cover 106 configured to connect with one another.

The cooling block 100 is configured to cool a heat-generating electronic component 10. In this example, the heat-generating electronic component 10 is a central processing unit (CPU). For instance, the heat-generating electronic component 10 may be part of a server operating within a data center. In use, the heat-generating electronic component 10 generates a significant amount of heat and can therefore benefit from cooling. It is contemplated that the heat-generating electronic component 10 could be any other suitable heat-generating electronic component (e.g., a graphics processing unit (GPU), a semiconductor, a memory unit, etc.).

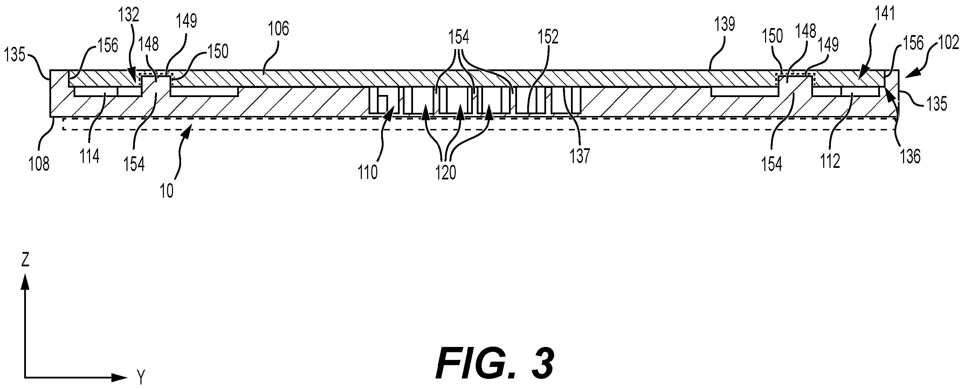

With reference to Figures 3, 6, and 8, the base 104 of the cooling block 100 includes a thermal transfer surface 108 disposed on a lower side of the base 104. The thermal transfer surface 108 is configured to be placed in thermal contact with the heat-generating electronic component 10. It is to be understood that the thermal transfer surface 108 can be in thermal contact with the heat-generating electronic component 10 whether the thermal transfer surface is in direct contact with the heat-generating electronic component 10 or a thermal interface material (e.g., a thermal paste, a thermal pad, a graphite sheet, etc.) is disposed therebetween with the express intention of improving the heat transfer between the heat-generating electronic component 10 and the cooling block 100. In certain implementations, there may also be the thermal transfer surface 108 disposed on an upper side of the cover 106 (not shown).

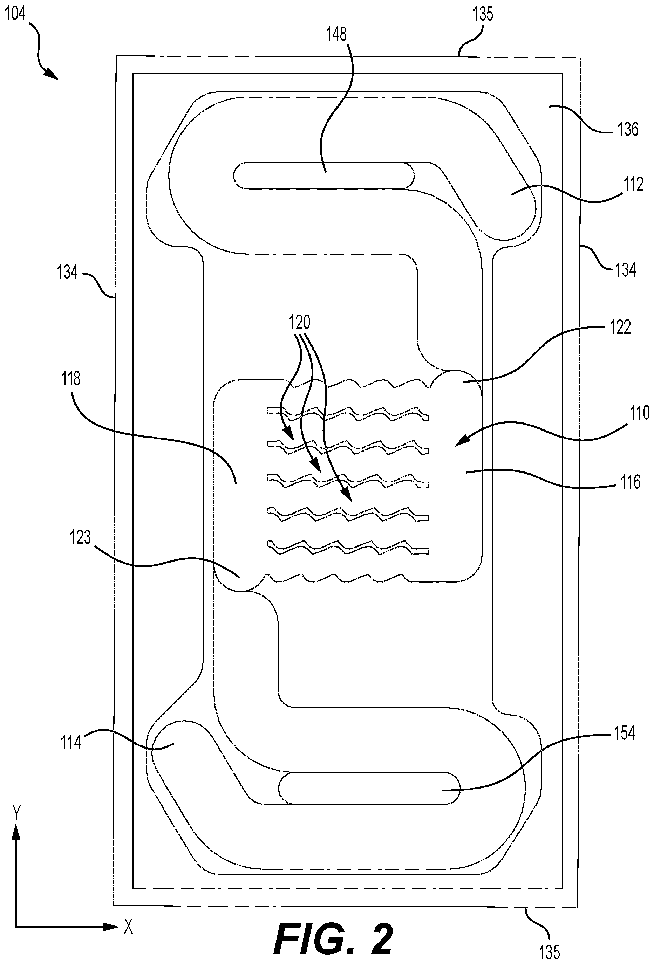

With reference to Figures 2 to 4 and 6 to 8, the base 104 and the cover 106, together, define an internal fluid conduit 110 in which a cooling fluid is circulated to absorb heat from the heat-generating electronic component 10.

As depicted in Figure 2, the fluid conduit 110 extends from an inlet 112 to an outlet 114. In this example, the inlet 112 and the outlet 114 are disposed near opposite corners of the cooling block 100. It is appreciated that, in alternative implementations, the inlet 112 and the outlet 114 could be disposed at different locations. In this implementation, the cooling fluid circulated through the fluid conduit 110 is demineralized water. However, it is contemplated that the cooling fluid may be capable of two-phase flow such that the cooling fluid can change phases from liquid to gas and vice-versa based on a temperature thereof. The cooling fluid circulating within the cooling block 100 will thus, at some point be in the liquid phase, however the cooling fluid may not necessarily be in the liquid phase throughout (e.g., the cooling fluid may evaporate from liquid to gas when its temperature reaches a certain value).

A path of the fluid conduit 110 is defined by the base 104 which is manufactured to have at least one open passage 120 (which may also be referred to as an open channel). With reference to Figure 2, a single passage 120 extends along a pathway defined longitudinally and transversely across the cooling block 100 (i.e., along the Y-axis and the X-axis). However, in alternative implementations, the passage 120 may extend only longitudinally across the cooling block 100 (i.e., along the Y-axis) or only transversely (i.e., along the X-axis).

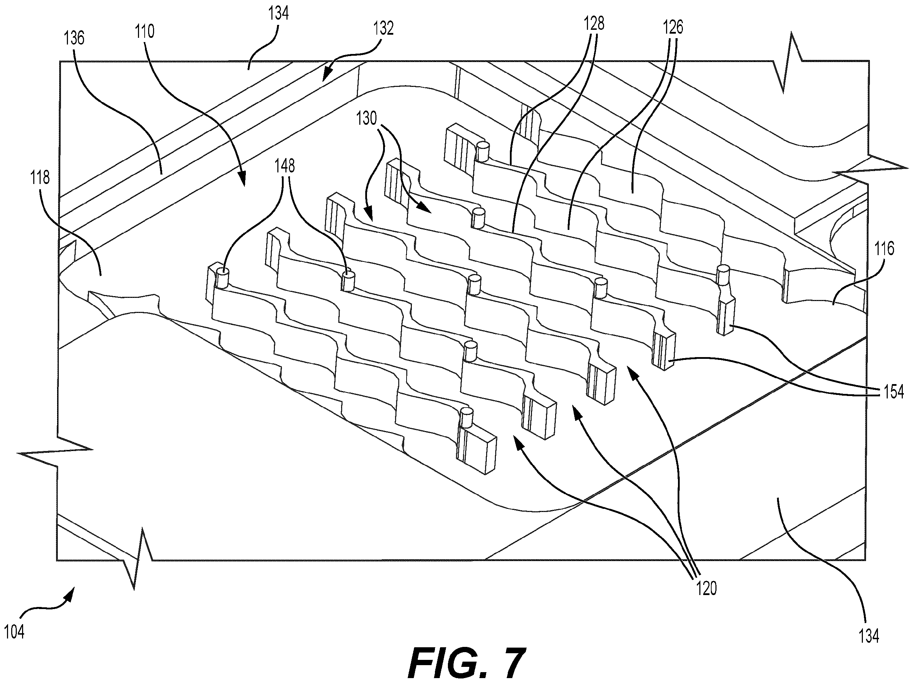

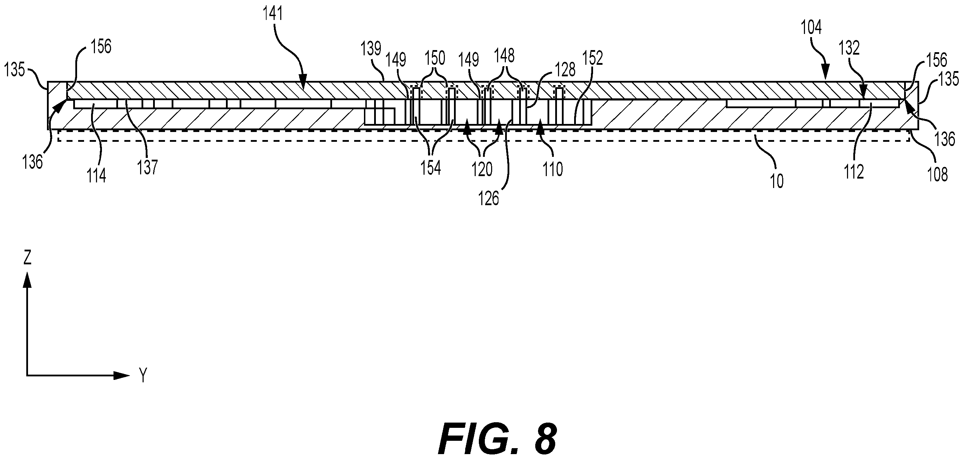

In some implementations, the base 104 includes a plurality of passages 120. In the implementations depicted in Figures 7 and 8, the fluid conduit 110 includes multiple passages 120 arranged in parallel with one another. In other words, as the cooling fluid flows from the inlet 112 to the outlet 114, the cooling fluid is split between the parallel passages 120. In this implementation, the fluid conduit 110 further includes an inlet manifold portion 116 which extends from the inlet 112, as well as an outlet manifold portion 118 which extends from the outlet 114. The passages 120 extend between the inlet manifold portion 116 and the outlet manifold portion 118, fluidly connecting the inlet manifold portion 116 and the outlet manifold portion 118. It is appreciated that, in this implementation, the plurality of passages 120 have substantially the same configuration and, therefore only one of the passages 120 will be referred to herein. In alternative implementations, the multiple passages 120 may be positioned in series with one another (not shown). In other words, as the cooling fluid flows from the inlet 110 to the outlet 112 of the fluid conduit 110, the cooling fluid flows through each passage 120 sequentially.

In certain implementations, the passage 120 is configured to promote turbulent flow while limiting flow separation and recirculation of the cooling fluid as it flows through the fluid conduit 110. This increases the heat absorbing capability of the cooling fluid which can therefore dissipate heat more efficiently from the heat-generating electronic component 10. In some implementations, as depicted in Figure 7, internal sidewalls 126, 128 may be scalloped shaped, meaning each of the internal side walls 126, 128 includes rounded sections 130 distributed along the internal walls 126, 128. In this implementation, the rounded sections 130 are distributed uniformly along the internal walls 126, 128. It is contemplated that the rounded sections 130 may be omitted. In some implementations, the passage 120 may include a plurality of pins (not shown) disposed along the passage 120 and extending upwards from the base 104 to deflect the cooling fluid flowing within the fluid conduit 110.

With reference to Figures 2 to 4 and 6 to 8, the base 104 will now be explained in further detail. As previously mentioned, the cover 106 is positioned atop the base 104. As depicted in Figures 3, 6, and 8, the base 104 defines a pocket 132 and the passage(s) 120 is defined in the pocket 132. The pocket 132 receives the cover 106. A shelf 136 is defined by side walls 134, 135 of the base 104 and extends around a perimeter of the base 104 (as depicted in Figure 2). The shelf 136 forms a lip or a ledge in which a portion of the cover 106 rests atop. In this implementation, a perimeter (or outer edge) of a lower surface 137 (also referred to as underside) of the cover 106 rests atop the shelf 136. In alternative implementations, only some of the side walls may define the shelf 136 such that the shelf 136 extends partially around the perimeter of the base 104.

In some implementations, the base 104 may further include inter-connectable members associated with the shelf 136 and the cover 106. For example, the inter-connectable members may include a male and a female component, such as a pin and an opening, configured to receive the pin. In some instances, the shelf 136 may include the pin and the cover 106 may include the opening to receive the pin. In another instance, the shelf 136 may include the opening while the cover 106 includes the pin. It is appreciated that a plurality of pins and openings may be disposed around the perimeter of the shelf 136 and the perimeter of the cover 106. It is contemplated that, in alternative implementations, the base 104 may not define a pocket 132 to receive the cover 106. Instead, the base 104 may include the inter-connectable members to retain the cover 106 on top of the base 104.

With reference to Figures 1, 3, 5, 6, 8, and 9, the cover 106 includes a cover body 141 which is a plate member that is generally planar and shaped to be received within the pocket 132. The lower surface 137 of the cover 106 provides a flat portion that closes off the fluid conduit 110 from its upper side.

As depicted in Figure 1, the cover 106 further includes an inlet connection 144, in fluid communication with the inlet 112, and an outlet connection 146, in fluid communication with the outlet 114. The inlet and outlet connections 144, 146 are connectable to piping (not shown) to route the cooling fluid to the cooling block 100 and discharge the cooling fluid from the cooling block 100, respectively. The piping may be fluidly connected to a fluid source (not shown).

As previously described, the base 104 and the cover 106 connect with one another. In implementations of the present technology, the cooling block 100 includes inter-engaging members which, upon engagement with one another, form a mechanical connection between the base 104 and the cover 106. The inter-engaging members of the present technology includes at least one protrusion 148 defined by the base 104 and at least one recess 150 defined by the cover 106. The mechanical connection is formed when at least a free end 149 of the protrusion 148 is received by the recess 150 when the cover 106 is positioned on the base 104. In alternative implementations, the protrusion 148 may be defined by the cover 106 and the recess 150 may be defined by the base 104.

With reference to Figures 3, 4, and 6 to 8, as previously described, the base 104 includes the protrusion 148. In implementations of the present technology, the protrusion 148 extends upwardly relative to a bottom 152 of the passage 120. Each protrusion 148 is configured to have a height higher than the shelf 136, relative to the bottom 152 of the passage 120. In some implementations, the protrusion 148 height is sufficient to avoid deformation of the passage 120 during manufacturing, when welding the cover 106 to the base 104. For example, the protrusion 148 extends at least 1.0 mm, e.g. around 2.0 mm, above the shelf 136 (and thus, above the fluid conduit 110).

With reference to Figures 3 to 6, 8 and 9, as previously described, the cover 106 includes the recess 150. Specifically, the lower surface 137 of the cover 106 defines the recess 150. In other words, the recess 150 is inset from the lower surface 137, extending partially upwards towards an outer side 139 of the cover 106. In other words, a thickness of a portion 151 of the cover 106 including the recess 150 is less than a thickness of the cover 106 not including the recess 150. In some implementations, the thickness of the portion 151 of the cover 106 including the recess 150 may be between 0.5 mm and 2.0 mm. In a specific example, the cover 106 (and the pocket 132 in which the cover 106 is positioned) is 3.0 mm in thickness and the recess 150 is 2.0 mm in depth, such that the portion 151 of the cover 106 including the recess 150 is 1.0 mm.

The recess 150 is configured to receive at least the free end 149 of the protrusion 148 associated with the base 104. In some implementations, the recess 150 is complementary in shape to the free end 149 of the protrusion 148. During manufacturing, the recess 150 may be formed by milling a piece of material from which the cover 106 is to be formed.

With reference to Figures 3 to 8, implementations of the protrusion 148 and the respective recess 150 will now be described in further detail.

In some implementations, the protrusion 148 is at least a portion of a passage wall 154. With specific reference to Figure 3, there are provided two protrusions 148. In this implementation, the protrusions 148 are passage walls 154 which define the passage 120. The passage walls 154 extend upwardly from the bottom 152 of the passage 120. Each of the passage walls 154 extend upwardly to a height higher than the height of the shelf 136 (relative to the bottom 152 of the passage 120). In other words, a free end of the passage wall 154 is higher than the shelf 136, such that the free end of the passage wall 154 is received by corresponding recesses 150 of the cover 106 when the cover 106 rests atop the shelf 136. During manufacturing, the passage walls 154 are formed by milling a piece of material from which the base 104 is to be formed. The passage walls 154 are milled to the height which is higher than the shelf 136.

In this implementation, the height of each of the passage walls 154 are substantially similar to one another. It is appreciated that, in alternative implementations, only some of the passage walls 154 may be protrusions 148. In other words, only some of the passage walls 154 may have a height higher than the shelf 136.

With continued reference to Figure 3, the lower surface 137 of the cover 106 defines two recesses 150. The recesses 150 are sized to receive the free end 149 of the passage wall 154. In some implementations, the recesses 150 are open to a side wall 156 of the cover 106. In other implementations, the recesses 150 may be spaced apart from the side wall 156 of the cover 106.

It is appreciated that, although only two protrusions 148 and two recesses 150 are described, the base 104 may define any number of passage walls 154, and thus protrusions 148, and the cover 106 may define any number of recesses 150 for receiving the free end 149 of the passage walls 154.

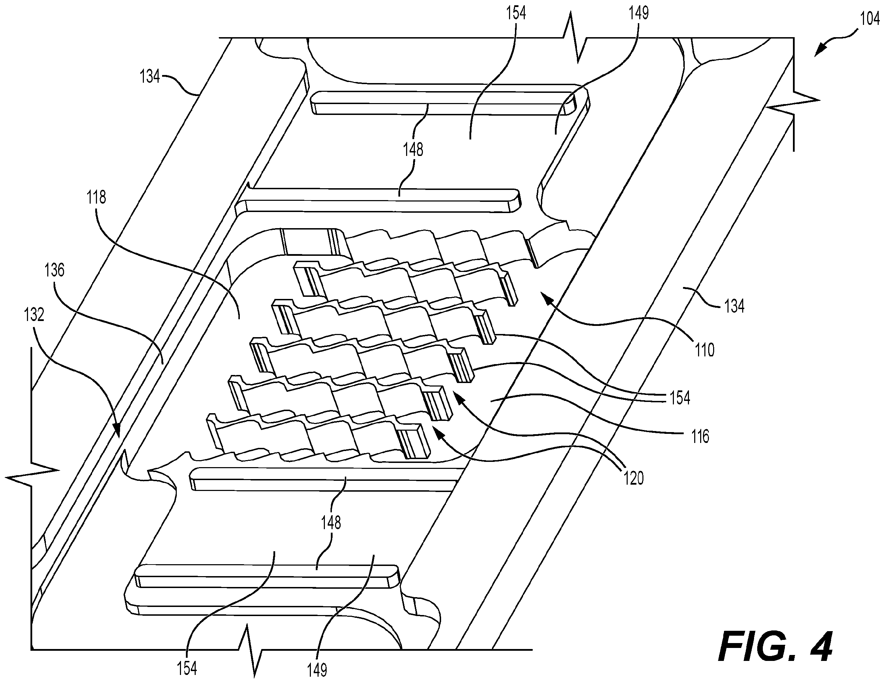

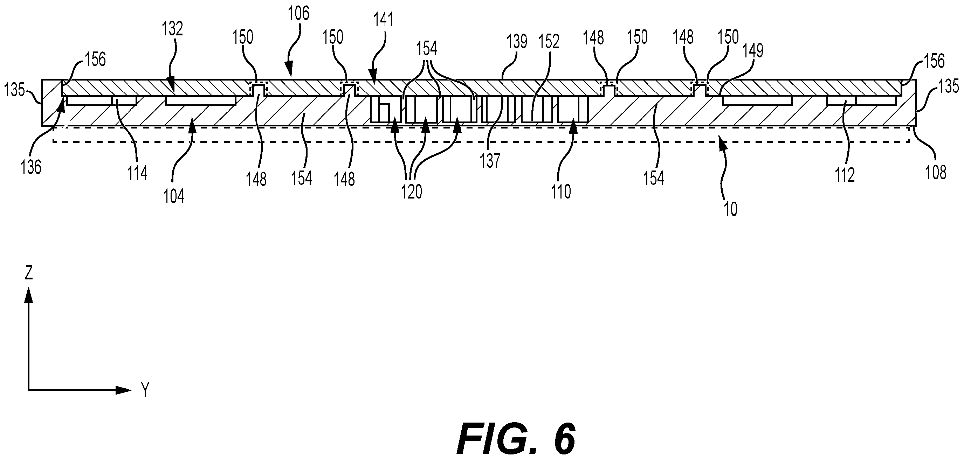

In some implementations, the protrusion 148 is an elongate member 148 disposed on the free end 149 of the passage walls 154. With specific reference to Figures 4 and 6, the base 104 includes two elongate members 148 disposed on the free end 149 of each of the passage walls 154. On each passage wall 154, the two elongate members 148 are spaced apart from and positioned parallel to one another. The elongate members 148 extend upwardly (along the Z-axis) from the free end 149 of the passage wall 154. Each elongate member 148 extends to a height higher than the height of the shelf 136 (relative to the bottom 152 of the passage 120), such that the elongate members 148 are received by corresponding recesses 150. Once the elongate members 148 are received by the recesses 150, the free end 149 of the passage wall 154 is substantially flush with the lower surface 137 of the cover 106. As depicted in Figure 6, the height of each of the elongate members 148 are substantially similar. However, in alternative implementations, the height of the elongate members 148 may vary relative to one another.

With reference to Figure 4, the two elongate members 148 extend transversely, from a point of connection, at the side wall 134 of the base 106. In this implementation, each elongate member 148 extends longitudinally across the respective passage wall 154 (that is, along the X-axis) as the passage walls 154 extend transversely to the side wall 134. As depicted, some of the elongate members 148 may be spaced apart from the side walls 134 of the base 104 and some of the elongate members 148 may be contingent with the side walls 134 of the base 104. In this implementation, the elongate members 148 extend substantially across an entire length of the passage walls 154. In other implementations, the elongate members 148 may extend partially across a length of the passage walls 154.

With continued reference to Figure 4, the elongate members 148 have an elongated linear configuration. In other implementations, the elongate members 148 may have a U-shaped, an L-shaped, a circular shape, or a hollow configuration (such as, an O-shaped and/or hollowed elliptical-shaped configuration) which may be formed from a single or multiple pieces.

It is contemplated that, the elongate members 148 may be positioned in a different orientation relative to the side walls 134. For example, in alternative implementations, the elongate members 148 may extend longitudinally, from a point of connection, at the side walls 134 (that is, along the Y-axis). It is further contemplated that the elongate members 148 may be positioned in different orientations relative to one another.

In this implementation, the elongate members 148 and the passage walls 154 are formed as a unitary piece. Specifically, the elongate members 148 are formed by milling. That is, a portion of the passage walls 154 are milled to form the elongate members 148 atop the free end 149 of the passage walls 154. It is contemplated that, in alternative implementations, the elongate members 148 are separate from the passage walls 154 and attached to the passage walls 154, for example by gluing, welding, fasteners, or any other means of attachment known in the art.

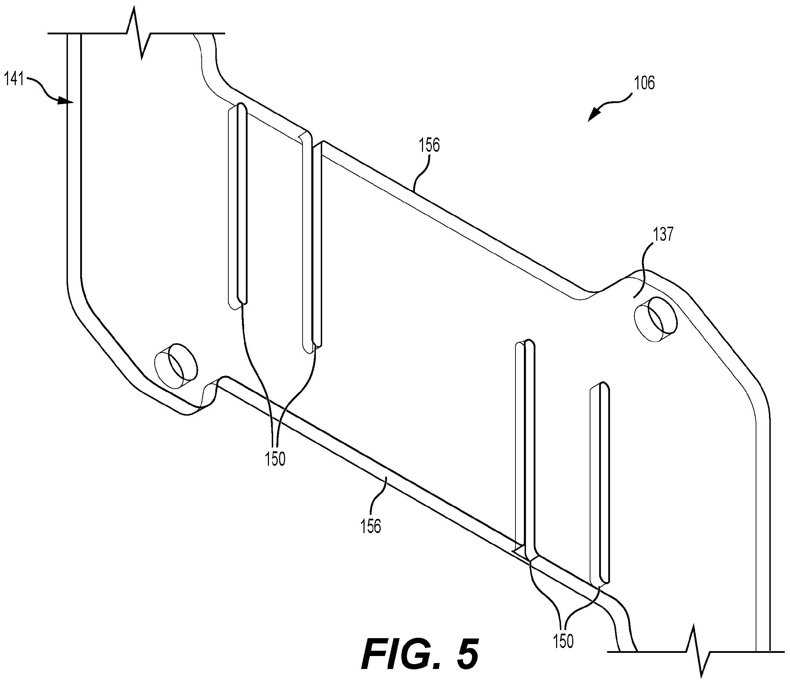

With reference to Figures 5 and 6, the lower surface 137 of the cover 106 defines four recesses 150, each configured to receive one of the elongate members 148. In this implementation, the recesses 150 have an elongated linear configuration. The recesses 150, associated with the elongate members 148 contingent with the side walls 134 of the base 104, are open to the side wall 156 of the cover 106. The recesses 150, associated with the elongate members 148 spaced apart from the sidewalls of the base 104, are spaced apart from the side wall 156 of the cover 106 (or closed to the sidewall 156).

It is contemplated that, in alternative implementations, the recesses 150 may have a different configuration. That is, in alternative implementations with the elongate members 148 having a U-shaped, L-shaped, a circular shape and/or hollowed configuration, the recesses 150 would be configured to have the complementary shape to receive one of the elongate members 148.

It will be appreciated that although only four protrusions 148 and four recesses 150 are described, the base 104 may define any number of elongate members 148 and the cover 106 may define any number of recesses 150 for receiving the elongate members 148. It is further contemplated that, in alternative implementations, only some passage walls 154 may have elongate members 148.

In some implementations, the protrusion 148 is a pin 148 disposed on the free end 149 of the passage wall 154. With specific reference to Figures 7 and 8, the base 104 includes a plurality of pins 148 spaced apart from one another along the free end 149 of the passage walls 154 (lying on a plane transverse to the Z-axis). Each of the pins 148 extends upwardly from the free end 149 of the passage walls 154 to a height higher than the height of the shelf 136 (relative to the bottom 152 of the passage 120), such that the pins 148 are received by corresponding recesses 150. Once the pins 148 are received by the recesses 150, the free end 149 of the passage wall 154 is substantially flush with the lower surface 137 of the cover 106. As depicted in Figure 8, the height of each of the pins 148 are substantially similar. However, in alternative implementations, the height of the pins 148 may vary relative to one another.

As depicted in Figure 7, each passage wall 154 includes at least one pin 148. In this implementation, the passage walls 154 do not have the same number of pins 148. As shown, some passage walls 154 include two pins 148, while other passage walls 154 include one pin 148. Furthermore, the pins 148 of adjacent passage walls 154 are not laterally aligned which may result in a better distribution of heat during welding. In alternative embodiments, the pins 148 of adjacent passage walls 154 may be laterally aligned.

It is contemplated that, in some implementations, each passage wall 154 includes the same number of pins 148. The pins 148 may be evenly spaced apart along the length of the passage walls 154 or, in other implementations, the pins 148 may be unevenly spaced apart. It is further contemplated that, in alternative implementations, only some passage walls 154 include pins 148.

In this implementation, the pins 148 have a circular cross section along a plane parallel to the bottom 152 of the passage 120 (i.e., X-Y plane). However, it is contemplated that, in alternative implementations, the pins 148 may have a U-shaped, an L-shaped, or a donut cross section and may be formed of a single or multiple pieces.

In this implementation, the pins 148 and the passage walls 154 are formed as a unitary piece. Specifically, the pins 148 are formed by milling. That is, a portion of the passage walls 154 are milled to form the pins 148 atop the free end 149 of the passage walls 154. It is contemplated that, in alternative implementations, the pins 148 are separate from the passage walls 154 and attached to the passage walls 154, for example by gluing, welding, fasteners, or any other means of attachment known in the art.

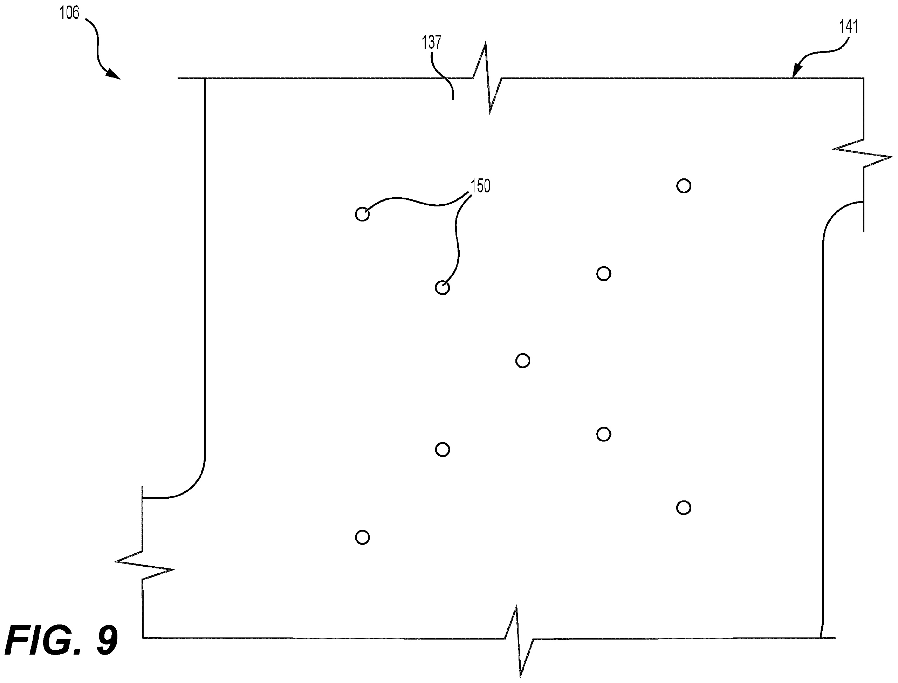

With reference to Figures 8 and 9, the lower surface 137 of the cover 106 defines a plurality of recesses 150, each recess 150 is configured to receive one of the pins 148 of the base 104. In this implementation, the recesses 150 have a circular cross section when taken through a plane parallel to the top side of the cover 106 (i.e., X-Y plane).

It is contemplated that, in alternative implementations, the recesses 150 may have a different configuration. That is, in alternative implementations with the pins 148 having a U-shaped, L-shaped, or donut cross section, the recesses 150 would be configured to have the complementary shape to receive one of the pins 148.

This configuration of pins 148 and recesses 150 is particularly advantageous when the passage walls 154 do not have a constant width along the longitudinal direction (for example, having the rounded sections 130). In particular, forming the recesses 150 to receive the irregular shaped passage walls 154 and/or elongate members 148 is challenging and it is easier and may be more convenient to manufacture the pins 148 and the recesses 150 having the constant cross sections as described above.

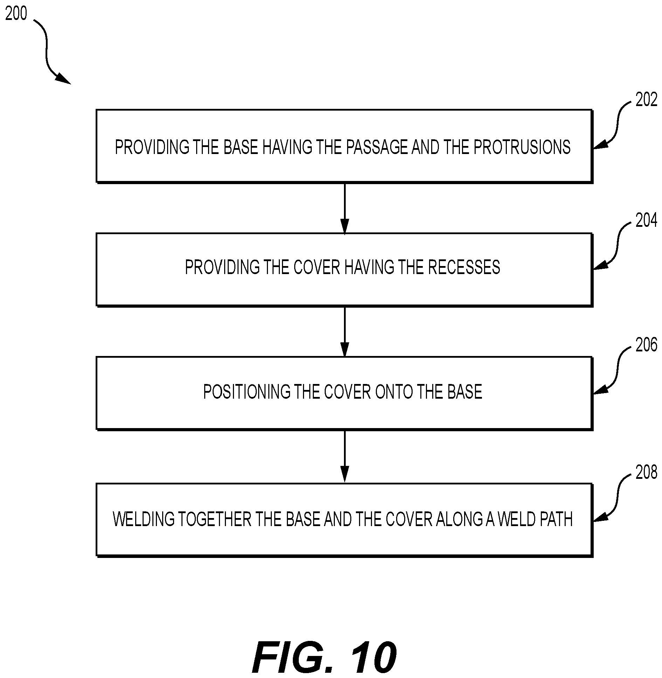

With reference to Figure 10, a method 200 of manufacturing the cooling block 100 of the present technology will now be described. Broadly, the method includes step 202 of providing the base 104 having the passage 120 and the protrusions 148, step 204 of providing the cover 106 having the recesses 150, step 204 of positioning the cover 106 having the recesses 150 onto the base 104, and step 206 of welding together the base 104 and the cover 106 along a weld path.

As previously discussed, in this implementation, the protrusions 148 of the base 104 are formed by milling the piece of material associated with the base 104. The recesses 150 of the cover 106 are formed by milling the piece of material associated with the cover 106. In the implementations of the present technology, the material of the base 104 and/or the cover 106 are copper or brass. However, it is contemplated that other metal materials may be used.

Once the base 104 and the cover 106 have been milled, the cover 106 is positioned on top of the base 104, closing the passage 120 to form the fluid conduit 110. When positioning the cover 106 onto the base 104, the protrusions 148 of the base 104 are received in the recesses 150 of the cover 106.

After forming the mechanical connection between the base 104 and the cover 106, the two pieces are welded together along a weld path which includes, at least a portion of, the mechanical connection. In other words, welding occurs along a portion of the outer side 139 of the cover 106 above the recesses 150. This forms a secure connection between the base 104 and the cover 106. As the height of the protrusions 148 are higher than the shelf 136 (relative to the bottom 152 of the passage 120), a thickness through which the welding needs to occur is reduced which, in turn, reduces the amount of energy required to form the secure connection. In other words, the thickness of the portion 151 of the cover 106 including the recesses 150 is less than the thickness of the portions of the cover 106 which do not include the at recesses 150 (for example, 1.0 mm). As a result, the welding is quick and requires a smaller amount of energy. It is appreciated that the amount of energy required is, in part, dependent upon the thickness of the portion 151 of the cover 106 including the at least one recess 150. That is, as the thickness is reduced, the amount of energy required during welding is also reduced.

In some implementations, welding is performed using a deep welding system such as, one or more of, laser plasma, friction, or ultrasound welding.

In some implementations, welding along the weld path may include continuously welding along the weld path. In other implementations, welding along the weld path may include spot welding along the weld path. In further alternative implementations, there may be a combination of the two.

In some implementations, the method 200 may include welding at the corners of the cover 106. For example, to form welded connections at the corners between the lower surface 137 of the cover 106 and the shelf 136 of the base 104. Alternatively, or complementary, the method 200 may include spot welding at the edge midpoints of the covers 106 and/or at the welding corners of the cover to the base. For example, to form welded connections at the edge midpoints between the lower surface 137 of the cover 106 and the shelf 136 of the base 104. The method 200 may include welding along a perimeter of the outer side of the cover 106. For example, to form a welded connection around the shelf 136. In certain implementations, the method may include welding the at least one protrusion 148 received in the at least one recess 150.

It is appreciated that, in some implementations of the present technology, various configurations of protrusions 148 may be used. For example, the base 104 may include a combination of protrusion types (that is, the passage wall 154, the elongate members 148, or the pins 148). Although only some configurations of protrusions 148 are described, it is contemplated that other configurations of protrusions 148 (and corresponding recesses 150) may be selected. For example, in alternative implementations in which pins are positioned along the fluid conduit 110, the pins 148 may extend from the bottom 152 of the passage 120 to a height higher than the shelf 136 and may be received by a respective recess 150 of the cover (not shown).

Although the cooling block 100 has been described with the protrusions 148 defined by the base 104 and the recesses 150 defined by the cover 106, it is appreciated that, in alternative implementations, the cover 106 may define the protrusions 148 and the base 104 may define the recesses 150.

The disclosed implementations of the cooling block 100 and the method of manufacturing thereof provides various benefits including, but not limited to, providing a mechanical connection between the base 104 and the cover 106 of the cooling block 100 formed by the engagement of the protrusions 148 and the recesses 150. During the manufacturing process, the welding performed on the outer side 139 the cover 106 is along, at least a portion, of this mechanical connection. The thickness of the portion 151 of the cover 106 including the recesses 150 is less than the thickness of the portion of the cover 106 not including the recesses 150. Thus, the energy required when welding the cover 106 to the base 104 is reduced which may lead to a decrease in operational costs. This may lead to a reduced risk of deformation of geometry of the cover 106 and/or the base 104 which may mitigate the likelihood of the cooling fluid short circuiting the fluid pathway of the cooling block 100.

In view of the various disclosures directed to a cooling block and method of manufacturing thereof, it will be understood that, although the implementations presented herein have been described with reference to specific features and structures, it is clear that various modifications and combinations may be made without departing from such disclosures. The specification and drawings are, accordingly, to be regarded simply as an illustration of the discussed implementations or implementations and their principles as defined by the appended claims, and are contemplated to cover any and all modifications, variations, combinations or equivalents that fall within the scope of the present disclosure.

## Claims

1. A method (200) for making a cooling block (100) for cooling a heat-generating electronic component (10), the method (200) comprising:
providing a base (104) having defined therein at least one open passage (120) and at least one protrusion (148) extending upwardly relative to a bottom of the at least one open passage (120);
providing a cover (106) which is configured to be positionable on the base (104) such that it closes the at least one open passage (120) to form at least one fluid conduit (110), wherein the cover (106) comprises:
an outer side (139), and
an underside (137) defining at least one recess (150) which is configured to receive at
least a free end (149) of the at least one protrusion (148);
positioning the cover (106) on the base (104) such that at least the free end (149) of the at least one protrusion (148) is received in the at least one recess (150) and the at least one open passage (120) is closed to form the at least one fluid conduit (110); and
welding together the cover (106) and the base (104), from the outer side (139) of the cover (106), along a weld path which includes at least a portion on the cover above the at least one recess.

2. The method (200) of claim 1, wherein the base (104) has side walls (134) defining a pocket (132), the at least one open passage (120) being defined in the pocket (132), the side walls (134) of the base (104) having a shelf (136) on which the cover (106) can sit, wherein a height of the at least one protrusion (148) from the bottom of the at least one open passage (120) is higher than a height of the shelf (136) from the bottom of the at least one open passage (120).

3. The method (200) of claim 1, wherein the base (104) has side walls (134) defining a pocket (132), the at least one open passage (120) being defined in the pocket (132), the side walls (134) of the base (104) having a shelf (136) on which the cover (106) can sit, further comprising inter-engageable members associated with the shelf (136) and the cover (106).

4. The method (200) of any of claims 1-3, wherein the cover (106) has a cover body (141), a thickness of the cover body (141) at a portion of the cover (106) including the at least one recess is less than a thickness of the cover body (141) at a portion not including the at least one recess.

5. The method (200) of any of claims 1-4, wherein the at least one protrusion (148) comprises at least one passage wall of the at least one open passage (120), the at least one passage wall having a passage wall free end which is received in the recess of the cover, and optionally wherein the at least one open passage (120) comprises two passages and the at least one passage wall separates the two passages.

6. The method (200) of any of claims 1-4, wherein the at least one open passage (120) includes at least one passage wall having a passage wall free end, and the at least one protrusion comprises at least one elongate member disposed on, and extending at least partially along, the passage wall free end.

7. The method (200) of claim 6, wherein the at least one open passage (120) extends transversely to a side wall of the base, at a point of connection to the side wall, and wherein the at least one elongate member is one of (i) contingent with the side wall of the base, or spaced from the side wall of the base.

8. The method (200) of claim 7, wherein the at least one elongate member comprises two elongate members which are disposed parallel to one another along the passage wall free end.

9. The method (200) of claim 7 or claim 8, wherein the at least one elongate member has a U-shaped, an L shaped or a hollow configuration.

10. The method (200) of any of claims 1-9, wherein the at least one protrusion comprises a plurality of pins spaced from one another along the passage wall free end, and the at least one recess comprises a plurality of recesses, each recess being sized and shaped to receive a respective one of the plurality of pins.

11. The method (200) of claim 10, wherein each pin has a circular, U-shaped, L-shaped or donut cross-section along a plane which is parallel to the bottom of the at least one open passage.

12. The method (200) of any of claims 1-11, further comprising forming the at least one recess by milling.

13. The method (200) of any of claims 1-12, further comprising forming at least a portion of the at least one protrusion by milling.

14. The method (200) of any of claims 1-13, wherein the welding comprises at least one of: welding corners of the cover to the base, welding edge midpoints of the cover to the base, welding the at least one protrusion within the at least one recess, and welding along a perimeter of the cover.

15. A cooling block (100) comprising a body (102) having defined therein at least one fluid conduit (110), the cooling block (100) made according to the method (200) of any of claims 1-14.
